# EUROPÄISCHE PATENTSCHRIFT

(11) **EP 2 270 856 B1**
(45) Veröffentlichungstag und Bekanntmachung des Hinweises auf die Patenterteilung: **14.01.2015**
(21) Anmeldenummer: 10184279.7
(22) Anmeldetag: 06.07.2001
(51) Int. Cl.: H01L 25/075, H01L 33/00, F21V 19/00, G09F 9/33

(54) **LED-Lichtquelle**
LED light source
Source de lumière de DEL

(30) Priorität: 12.07.2000 AT 12052000
(43) Veröffentlichungstag der Anmeldung: 05.01.2011
(62) Teilanmeldung aus: 01984193.1
(73) Patentinhaber: Tridonic Jennersdorf GmbH, 8380 Jennersdorf (AT)
(72) Erfinder: Tasch, Stefan, 8380 Jennersdorf (AT); Pachler, Peter, 8042 Graz (AT); Wilczek, Klaus, Peter, 83404 Ainring (AT); Hochfilzer, Christian, 8010 Graz (AT)
(74) Vertreter: Rupp, Christian

(56) Entgegenhaltungen:
- EP-A1- 1 139 439
- EP-A2- 0 588 040
- WO-A-01/47039
- WO-A1-97/37385
- JP-A- 11 320 962
- US-A- 5 936 353
- PATENT ABSTRACTS OF JAPAN Bd. 1995, Nr. 3, 28. April 1995 (1995-04-28) -& JP 06, 349892, A, (MATSUSHITA ELECTRIC), 22. Dezember 1994 (1994-12-22)
- PATENT ABSTRACTS OF JAPAN Bd. 1996, Nr. 2, 29. Februar 1996 (1996-02-29) -& JP 07, 263754, A, (NICHIA CHEM IND), 13. Oktober 1995 (1995-10-13)

## Beschreibung

### TECHNISCHES GEBIET

Die vorliegende Erfindung betrifft eine LED-Lichtquelle hoher Lichtstärke mit mindestens zwei LED-Dice, wobei die LEDs auf einer thermisch leitfähigen Leiterplatte angeordnet werden, sodass im Betrieb die Wärme durch die Leiterplatte hindurch abgeleitet wird.

### STAND DER TECHNIK

Aus der US-5936353-A ist bereits bekannt, LEDs mit hoher Dichte auf einer Leiterplatte aus Keramik oder Metall anzuordnen. Dies hat den Vorteil, dass im Betrieb die Wärme durch die Leiterplatte hindurch abgeführt werden kann. Es ist so möglich, auf der Rückseite einen Kühlkörper aufzusetzen. Geeignete Materialien sind BeO, Al₂O₃, Kupfer oder Aluminium oder A1N.

Zweck dieser Maßnahme ist natürlich, eine möglichst hohe Leuchtdichte zu erhalten, und dazu ist auch eine Optimierung der Befestigung und elektrischen Kontaktierung notwendig, wie im Folgenden ausgeführt wird.

LEDs verarbeitet auf Lead-Frames basierend auf Die- und Wirebonding-Prozessen und neuerdings mit Flip-Chip Technik sind Stand der Technik.

Die derzeit effizientesten blauen und grünen LEDs basieren auf GaN auf Saphir-Substraten. Aufgrund des nichtleitenden Substrates bei diesem Aufbau sind beide Kontakte an der Oberseite des LED-Die angeordnet. Die Lichtemission, welche innerhalb der GaN-Schicht des LED-Dice entsteht, wird durch die Kontaktflächen jedoch erheblich eingeschränkt. Derart kann die externe Leistungsausbeute dieser LED-Dice bis zu einem Faktor 2 gesteigert werden, wenn diese mit den Kontaktflächen nach unten mittels einer Flip-Chip Technologie verarbeitet werden (für Flip Chip Technologien siehe z.B. US-5438477-A, US-5111279-A). Ähnliche Vorteile können bei roten und orangen Dice, welche auf transparenten Substraten basieren, erzielt werden, sofern diese face down bzw. mit einer Seitenfläche gebondet werden, so dass die Emission durch die gegenüberliegende Fläche erfolgt. Die elektrische Kontaktierung erfolgt in letzterem Fall über die Stirnflächen.

Es wird ebenso auf den folgenden Stand der Technik Bezug genommen: JP 06.349892; JP 07.263754, JP 08148723, WO 01/47039, JP 11320962 und WO 9737385.

Dieser wesentliche Vorteil der Flip-Chip Technologie zur Verarbeitung der LED-Dice im Hinblick auf die Erzeugung von hoher Helligkeit auf geringem Raum kann noch gesteigert werden, wenn LEDs in Array-Form mittels Flip-Chip Technologie direkt auf die Leiterplatte aufgebracht werden.

Ein besonders wichtiger Aspekt bei dieser Anordnung ist das Thermomanagement. Die Kontaktflächen zwischen dem Die und den Kontaktpads der Leiterplatte sind geringer im Vergleich zu einer konventionellen Die/Wire Bonding Technologie. Aus diesem Grund ist die thermische Leitfähigkeit des Verbindungsmaterials zwischen LED-Die und Leiterplatte noch essentieller als bei der konventionellen Chip-On-Board Technologie.

Außerdem werden an die Strukturierung der Leiterbahnen hohe Anforderungen gestellt. Die maximale Strukturierungsbreite liegt im Bereich von 50-100 µm. Da typischerweise aufgrund technologischer Limitationen die maximale Strukturbreite mit der Schichtdicke der Leiterbahnen korreliert, darf diese ebenfalls maximal diese Werte annehmen. Im Hinblick auf eine gute thermische Ableitung ist eine gute Wärmeabführung der Leiterbahnen, die durch die Art der Leiterbahn und deren Schichtdicke bestimmt ist, essentiell. Zusätzliche Wärmeableitung vom Die auf die Leiterplatine kann durch den Einsatz einer thermisch leitfähigen Vergussmaße, die zwischen Die und Leiterplatte eingebracht wird (Underfill), erreicht werden.

Weiters sind besondere Vorkehrungen zu treffen, dass bei der Kontaktierung der Dice kein Kurzschluss zwischen den beiden Kontaktstellen entsteht.

### OFFENBARUNG DER ERFINDUNG

Es ist Aufgabe der vorliegenden Erfindung gemäß den Ansprüchen 1 und 3 LED-Arrays mit möglichst hoher Helligkeit bei möglichst geringer Baugröße zu realisieren.

Zur Erzielung einer hohen Leuchtdichte ist es zweckmäßig, wenn mehr als 4 Dice, teilweise seriell und teilweise parallel geschaltet, aufgepresst werden.

Zur Luftkühlung kann auf der Rückseite der Leiterplatte ein Kühlkörper aufgebracht werden, z.B. angeklebt werden. Man wird diesen meist so dimensionieren, dass dessen maximale Temperatur bei Dauerbetrieb um höchstens 45°C über der Umgebungstemperatur liegt.

Zum Ankleben des Kühlkörpers kann eine dünne, beidseitig beschichtete Klebematte verwendet werden, es kann aber auch eine beidseitig beschichtete Kupferfolie zum Ankleben des Kühlkörpers verwendet werden.

Anstatt den Kühlkörper anzukleben, kann er an die Rückseite der Leiterbahn flächig angelötet werden. Zum Anlöten des Kühlkörpers kann ein Vakuum-Lötofen verwendet werden.

Anstatt einer Luftkühlung kann auf der Rückseite der Leiterplatte eine elektrische Kühlung aufgebracht werden.

Es ist für Leuchtdichte und Thermomanagement zweckmäßig, wenn LED-Dice mit einer Grundfläche zwischen 300 und 700 µm² aufgepresst werden.

Die thermisch leitfähige Leiterplatte kann zumindest eine keramische Schicht beinhalten, oder man kann als Leiterplatte eine Metallkernleiterplatte verwenden.

Gemäß einer anderen Ausführungsform kann als Leiterplatte ein Keramikkörper verwendet werden, auf dessen Oberseite die Leiterbahnen aufgebracht sind und dessen Oberfläche derart ausgeformt ist, dass dieser als Kühlkörper dient. Auf diese Weise braucht kein zusätzlicher Kühlkörper mit der Leiterplatte verbunden werden.

Schließlich ist es zweckmäßig, wenn die Kontaktflächen auf der Leiterbahn oval oder rechteckig sind und eine Länge aufweisen, die annähernd der Kantenlänge des LED-Die entspricht. Auf diese Weise ergeben sich möglichst große Kontaktstellen, was für die elektrische, aber besonders für die thermische Leitfähigkeit wichtig ist.

### BESTE AUSFÜHRUNGSFORM DER ERFINDUNG

Anhand eines Beispiels wird die vorliegende Erfindung näher erläutert. Man verwendet eine Keramikleiterplatte (bestehend aus Al₂O₃, A1N, BN, BeO, ..), die mit Metallen, wie Cu, Ag/Pd, Au beschichtet ist. Hierbei werden bevorzugt Dickschichtkeramikleiterplatten, also Keramikleiterplatten, bei denen die Leiterbahnen mittels einer Siebdrucktechnik aufgebracht sind, eingesetzt. Weiters können Leiterplatten mit galvanisch abgeschiedenen Metallisierungen oder mittels Dünnschichttechnik aufgebrachten Metallisierungen eingesetzt werden. Die Strukturierung der Leiterplatte erfolgt mittels photolithographischer Techniken bzw. bei Dickschichtsystemen direkt beim Aufdruck.

Auf die Leiterbahnen wird eine isolierende Schicht aufgebracht, die sich nicht durchgehend über die Oberfläche der Leiterplatte erstreckt, sondern Ausnehmungen über den Kontaktzonen aufweist. In einer bevorzugten Variante sind diese Ausnehmungen derart ausgeführt, dass diese rechteckige oder ovale Form aufweisen, um eine möglichst große Fläche auf der Kontaktseite des LED-Die zu kontaktieren.

Es werden dann Kontaktbumps (bestehend aus Lotmaterialien, NiAu, Au oder ähnlichem) auf den LED-Die aufgebracht. Diese können beispielsweise mittels einer Laserschweißtechnik oder mittels Wire Bonding Prozessen. aufgebracht werden und aus einem niedrigschmelzenden Lötmaterial oder Au bestehen. Kontakte, die über derartige Bumps ausgeführt sind, weisen allerdings den Nachteil auf, dass der Abstand von den Kontaktflächen des Die relativ zur Leiterplatte durch die Bumphöhe (> 50 µm) vorgegeben wird, wodurch eine gute Wärmeableitung vom Die zur Leiterplatte behindert wird. Alternativ zu den Bumps werden Kontaktschichten auf die Leiterplatten aufgebracht, die als Kontakte dienen. Die Schichtdicken dieser Schichten werden im Bereich von 5-50 µm gewählt.

Anschließend werden die Dice auf der Leiterplatte mittels einer Pick- and Place Apparatur platziert. Dann erfolgt ein gezieltes Aufheizen und anschließendes Abkühlen der aufgesetzten Dice, so dass das Lot oder Au schmilzt und dann erstarrt, wodurch die Dice auf der Leiterplatte fixiert werden. Alternativ zum Löten wird zum Befestigen des LED-Dice auf der Leiterplatte ein Thermocompressionsverfahren eingesetzt. Die LED-Dice werden derart aufgesetzt bzw. die Metallisierung ist in einer Art strukturiert, dass jedem LED-Die eine Mindestmetallisierungsfläche zwischen 0,5 und 5 mm² zugeordnet ist.

Um Entladungen über den LED-Die beim Aufsetzen zu verhindern, kann optional aus ESD-Gründen eine Diode antiparallel zu den LED aufgesetzt werden.

Es ist natürlich möglich, dass zumindest ein LED-Die eine andere Emissionsfarbe als die anderen aufweist und dessen Betriebsstrom unabhängig von dem Betriebsstrom der anderen geregelt werden kann, sodass Mischfarben erzeugt werden können.

## Patentansprüche

1. LED-Lichtquelle mit mindestens zwei LED-Dice,
wobei die LED-Dice auf einer thermisch leitfähigen Leiterplatte angeordnet sind,
so dass im Betrieb die Wärme durch die Leiterplatte hindurch abgeleitet wird,
wobei die Leiterplatte mit Ausnahme von Kontaktflächen mit einer isolierenden Schicht versehen ist,
wobei auf den Kontaktelektroden der LED-Dice auf einer Fläche Kontaktbumps oder Kontaktschichten mit einer Maximalhöhe von 100 µm bestehend aus einem Lotmaterial mit guter thermischer Leitfähigkeit aufgebracht sind,
wobei die LED-Dice mittels einer Flip-Chip Technik mit den Kontaktbumps oder Kontaktschichten nach unten auf die Kontaktflächen der Leiterplatte oder in deren unmittelbare Nähe aufgepresst und gleichzeitig oder anschließend mittels Ultraschall und/oder thermisch verlötet sind, dadurch charakterisiert, dass eine thermisch leitfähige Vergussmasse zwischen die LED-Dice und die Leiterplatte gegeben ist, und dass
als Leiterplatte ein Keramikkörper verwendet wird, auf dessen Oberseite die Leiterbahnen aufgebracht sind und dessen Oberfläche derart ausgeformt ist, dass dieser als Kühlkörper dient.

2. LED-Lichtquelle nach Anspruch 1,
**dadurch gekennzeichnet,**
**dass** auf den Kontaktelektroden der LED-Dice metallische, insbesondere aus Gold bestehende Kontaktbumps oder Kontaktschichten aufgebracht sind.

3. LED-Lichtquelle mit mindestens zwei LED-Dice, wobei die LED-Dice auf einer thermisch leitfähigen Leiterplatte angeordnet sind, so dass im Betrieb die Wärme durch die Leiterplatte hindurch abgeleitet wird,
wobei die Leiterplatte mit Ausnahme von Kontaktflächen mit einer isolierenden Schicht versehen ist,
wobei Kontaktschichten mit einer Dicke von 1-50 µm auf den Kontaktflächen der Leiterplatte aufgebracht sind,
wobei die LED-Dice mittels einer Flip-Chip Technik, vorzugsweise mit ihren Kontaktelektroden nach unten, auf die Kontaktschichten der Leiterplatte oder in deren unmittelbare Nähe aufgepresst und gleichzeitig oder anschließend mittels Ultraschall und/oder thermisch verlötet sind, dadurch charakterisiert, dass eine thermisch leitfähige Vergussmasse zwischen die LED-Dice und die Leiterplatte gegeben ist, und dass
als Leiterplatte ein Keramikkörper verwendet wird, auf dessen Oberseite die Leiterbahnen aufgebracht sind und dessen Oberfläche derart ausgeformt ist, dass dieser als Kühlkörper dient.

4. LED-Lichtquelle nach dem Anspruch 3, **dadurch gekennzeichnet, dass** metallische, insbesondere aus Gold bestehende Kontaktschichten auf den Kontaktflächen der Leiterplatte aufgebracht sind.

5. LED-Lichtquelle nach einem der vorhergehenden Ansprüche,
**dadurch gekennzeichnet,**
**daß** die LED-Dice eine Emissionsfarbe blau, grün, rot oder orange aufweisen.

6. LED-Lichtquelle nach einem der vorhergehenden Ansprüche,
**dadurch gekennzeichnet, daß** zumindest ein LED-Die eine andere Emissionsfarbe als die anderen LED-Dice aufweist.

7. LED-Lichtquelle nach dem Anspruch 5 oder 6, **dadurch gekennzeichnet, daß** Betriebströme von LED-Dice unterschiedlicher Emissionsfarbe unabhängig regelbar sind.

8. LED-Lichtquelle nach einem der vorhergehenden Ansprüche, **dadurch gekennzeichnet, dass** mehr als 4 Dice, teilweise seriell und teilweise parallel geschaltet sind.

9. LED-Lichtquelle nach einem der vorhergehenden Ansprüche,
**dadurch gekennzeichnet, dass** auf der Rückseite der Leiterplatte ein Kühlkörper zur Luftkühlung aufgebracht ist.

10. LED-Lichtquelle nach Anspruch 9, **dadurch gekennzeichnet, dass** der Kühlkörper an die Leiterplatte angeklebt ist.

11. LED-Lichtquelle nach einem der Ansprüche 1 bis 10, **dadurch gekennzeichnet, dass** die Kontaktflächen auf der Leiterbahn oval oder rechteckig sind und eine Länge aufweisen, die annähernd der Kantenlänge des LED-Die entspricht.

## Claims

1. LED light source comprising at least two LED dice,
wherein the LED dice are arranged on a thermally conductive printed circuit board, such that during operation the heat is dissipated through the printed circuit board,
wherein the printed circuit board is provided with an insulating layer with the exception of contact areas,
wherein contact bumps or contact layers having a maximum height of 100 µm consisting of a solder material having good thermal conductivity are applied on the contact electrodes of the LED dice on an area,
wherein the LED dice by means of a flip-chip technique with the contact bumps or contact layers downwards are pressed onto the contact areas of the printed circuit board or in direct proximity thereto and at the same time or subsequently are soldered by means of ultrasound and/or thermally, **characterized in that**
a thermally conductive potting compound is provided between the LED dice and the printed circuit board, and **in that**
the printed circuit board used is a ceramic body, to the top side of which the conductor tracks are applied and the surface of which is shaped in such a way that said ceramic body serves as a heat sink.

2. LED light source according to Claim 1,
**characterized**
**in that** metallic contact bumps or contact layers, in particular contact bumps or contact layers consisting of gold, are applied on the contact electrodes of the LED dice.

3. LED light source comprising at least two LED dice,
wherein the LED dice are arranged on a thermally conductive printed circuit board, such that during operation the heat is dissipated through the printed circuit board,
wherein the printed circuit board is provided with an insulating layer with the exception of contact areas,
wherein contact layers having a thickness of 1 - 50 µm are applied on the contact areas of the printed circuit board,
wherein the LED dice by means of a flip-chip technique, preferably with their contact electrodes downwards, are pressed onto the contact layers of the printed circuit board or in direct proximity thereto and at the same time or subsequently are soldered by means of ultrasound and/or thermally, **characterized in that**
a thermally conductive potting compound is provided between the LED dice and the printed circuit board, and **in that**
the printed circuit board used is a ceramic body, to the top side of which the conductor tracks are applied and the surface of which is shaped in such a way that said ceramic body serves as a heat sink.

4. LED light source according to Claim 3, **characterized in that** metallic contact layers, in particular contact layers consisting of gold, are applied on the contact areas of the printed circuit board.

5. LED light source according to any of the preceding claims,
**characterized**
**in that** the LED dice have a blue, green, red or orange emission colour.

6. LED light source according to any of the preceding claims,
**characterized in that** at least one LED die has a different emission colour from the other LED dice.

7. LED light source according to Claim 5 or 6, **characterized in that** operating currents of LED dice of different emission colours can be regulated independently.

8. LED light source according to any of the preceding claims,
**characterized in that** more than 4 dice are connected partly in series and partly in parallel.

9. LED light source according to any of the preceding claims,
**characterized in that** a heat sink for air cooling is applied on the rear side of the printed circuit board.

10. LED light source according to Claim 9, **characterized in that** the heat sink is adhesively bonded onto the printed circuit board.

11. LED light source according to any of Claims 1 to 10, **characterized in that** the contact areas on the conductor track are oval or rectangular and have a length corresponding approximately to the edge length of the LED die.

## Revendications

1. Source de lumière à LED avec au moins deux puces à LED,
dans laquelle les puces à LED sont disposées sur un circuit imprimé thermiquement conducteur, de telle sorte qu'en fonctionnement la chaleur est évacuée à travers le circuit imprimé,
dans laquelle le circuit imprimé, à l'exception de surfaces de contact, est pourvu d'une couche isolante,
dans laquelle des bosses de contact ou des couches de contact avec une hauteur maximale de 100 µm consistant en un matériau de soudage ayant une bonne conductivité thermique sont montées sur une surface sur les électrodes de contact des puces à LED,
dans laquelle les puces à LED sont engagées par pression sur les surfaces de contact du circuit imprimé ou à proximité immédiate de celles-ci avec les bosses de contact ou les couches de contact vers le bas au moyen d'une technique à puce retournée, et sont soudées simultanément ou ultérieurement au moyen d'ultrasons et/ou thermiquement,
**caractérisée en ce qu'**une masse de scellement thermiquement conductrice est mise entre les puces à LED et le circuit imprimé, et
**en ce qu'**un corps en céramique est utilisé comme circuit imprimé, les pistes conductrices étant montées sur sa surface supérieure et sa surface supérieure étant formée de telle sorte qu'il sert de dissipateur de chaleur.

2. Source de lumière à LED selon la revendication 1,
**caractérisée en ce que**
des bosses de contact ou des couches de contact en métal, en particulier composées d'or, sont montées sur les électrodes de contact des puces à LED.

3. Source de lumière à LED avec au moins deux puces à LED, dans laquelle les puces à LED sont disposées sur un circuit imprimé thermiquement conducteur de telle sorte qu'en fonctionnement la chaleur est évacuée à travers le circuit imprimé,
dans laquelle le circuit imprimé, à l'exception de surfaces de contact, est pourvu d'une couche isolante,
dans laquelle des couches de contact avec une épaisseur de 1-50 µm sont montées sur les surface de contact du circuit imprimé,
dans laquelle les puces à LED sont engagées par pression, de préférence avec leurs électrodes de contact vers le bas, sur les surfaces de contact du circuit imprimé ou à proximité immédiate de celles-ci au moyen d'une technique à puce retournée, et sont soudées simultanément ou ultérieurement au moyen d'ultrasons et/ou thermiquement,
**caractérisée en ce qu'**une masse de scellement thermiquement conductrice est mise entre les puces à LED et le circuit imprimé, et
**en ce qu'**un corps en céramique est utilisé comme circuit imprimé, les pistes conductrices étant montées sur sa surface supérieure et sa surface supérieure étant formée de telle sorte qu'il sert de dissipateur de chaleur.

4. Source de lumière à LED selon la revendication 3,
**caractérisée en ce que**
des couches de contact en métal, en particulier composées d'or, sont montées sur les surfaces de contact du circuit imprimé.

5. Source de lumière à LED selon l'une quelconque des revendications précédentes,
**caractérisée en ce que**
les puces à LED présentent une couleur d'émission bleue, verte, rouge ou orange.

6. Source de lumière à LED selon l'une quelconque des revendications précédentes,
**caractérisée en ce que**
au moins une puce à LED présente une autre couleur d'émission que les autres puces à LED.

7. Source de lumière à LED selon la revendication 5 ou 6,
**caractérisée en ce que**
les courants de fonctionnement de puces à LED de couleur d'émission différente sont réglables indépendamment.

8. Source de lumière à LED selon l'une quelconque des revendications précédentes,
**caractérisée en ce que**
plus que 4 puces sont montées en partie en série et en partie en parallèle.

9. Source de lumière à LED selon l'une quelconque des revendications précédentes,
**caractérisée en ce que**
un dissipateur de chaleur destiné à un refroidissement à air est monté au dos du circuit imprimé.

10. Source de lumière à LED selon la revendication 9,
**caractérisée en ce que**
le dissipateur de chaleur est collé au circuit imprimé.

11. Source de lumière à LED selon l'une quelconque des revendications 1 à 10,
**caractérisée en ce que**
les surfaces de contact sur la piste conductrice sont ovales ou rectangulaires et présentent une longueur qui correspond approximativement à la longueur d'arête de la puce à LED.
